# EUROPÄISCHE PATENTSCHRIFT

(11) **EP 0 545 460 B1**
(45) Veröffentlichungstag und Bekanntmachung des Hinweises auf die Patenterteilung: **12.03.1997**
(21) Anmeldenummer: 92203541.5
(22) Anmeldetag: 18.11.1992
(51) Int. Cl.: C23C 16/44, C23C 16/50, C23C 16/54, C03C 17/245

(54) **CVD-Verfahren zur Beschichtung ausgedehnter Substrate**
CVD process for coating extensive substrates
Procédé CVD pour le revêtement des substrats à grande surface

(30) Priorität: 23.11.1991 DE 4138541
(43) Veröffentlichungstag der Anmeldung: 09.06.1993
(73) Patentinhaber: Philips Patentverwaltung GmbH, 22335 Hamburg (DE); Philips Electronics N.V., 5621 BA Eindhoven (NL)
(72) Erfinder: Lydtin, Hans Jürgen, Dr., W-2000 Hamburg 1 (DE); Ritz, Arnd, Dr., W-2000 Hamburg 1 (DE)
(74) Vertreter: Volmer, Georg, Dipl.-Ing.

(56) Entgegenhaltungen:
- EP-A- 0 388 800
- WO-A-91/17285
- DE-A- 4 016 765

## Beschreibung

Die Erfindung betrifft ein CVD-Verfahren zur Beschichtung großflächiger Substrate, wobei eine Anregung von Ausgangsstoffen und die Beschichtung mindestens eines auf einem Substrathalter angeordneten Substrats in durch eine Trennwand getrennten Bereichen stattfindet, die angeregten Ausgangsstoffe durch eine Öffnung in der Trennwand vom Anregungsbereich in den Beschichtungsbereich geleitet werden und der Substrathalter relativ zu der Öffnung bewegt wird.

Beispiele für Anwendungen erfindungsgemäß hergestellter Schichten aus dem optischen Bereich sind Interferenzfilter für die Röhren von Projektions-Fernsehgeräten, Farbtrennfilter für optische Systeme, Wärmereflexionsschichten für Halogenlampen und Wellenleiter für optische Kommunikation.

Ein Verfahren der eingangs genannten Art ist aus DE 39 26 023 A1 bekannt. Die Anregung einer Gaskomponente, die keine abscheidungsfähigen Produkte bildet, erfolgt dabei in einem Vorraum, der vom Substrat durch die eigentliche Reaktionszone getrennt wird. Die andere Komponente des Reaktionsgases wird seitlich in den angeregten Gasstrom eingeführt, was zu asymmetrischen Strömungsprofilen und damit ungleichmäßiger Abscheidung führen kann, in Randbereichen zu unerwünschten Partikelausscheidungen Anlaß gibt und ein Zuwachsen des Gaseinlasses prinzipiell nicht vermeidet. Dies ist besonders ungünstig, da in den dargestellten Anordnungen eine feste Verbindung zwischen Anregungseinheit und Abscheidezone vorgesehen ist.

Aus EP-A-0 388 800 ist ein Plasmareaktor und ein Substratbehandlungsverfahren bekannt, der erste Mittel zur Einschließung eines Plasmas und zweite Mittel zur Positionierung des Plasmas in den ersten Mitteln enthält. Das Substrat wird in einem Behandlungsraum, der mit dem Raum Zur Einschließung des Plasmas durch eine Apertur verbunden ist, beaufschlagt.

Aufgabe der Erfindung ist es, ein schnelles und preisgünstiges Verfahren zur homogenen Beschichtung von großflächigen Substraten mit uniformen einphasigen oder auch mehrphasigen Schichten zu schaffen. Solche Schichten können z.B. kristalline und amorphe Strukturen enthalten, wie etwa Kristallite in Glas, z.B. Glaskeramik mit submikroskopischen kristallinen Einlagerungen. Dabei werden insbesondere bei Herstellung von optischen Schichten Schichtdickeninhomogenitäten von unter ±1% bei einer idealen Mischung der zur Schichtbildung benötigten Komponenten gefordert.

Diese Aufgabe wird erfindungsgemäß nach Anspruch 1 dadurch gelöst, daß sämtliche Prozeßgase in den Anregungsbereich geführt werden, daß die angeregten Prozeßgase danach durch eine einzige Öffnung einer zugeordneten Blende in den Beschichtungsbereich geführt werden, daß die Wandungsdicke der Blende höchstens 1 mm beträgt, daß die lichten Weiten wesentlich kleiner als die Abmessungen des Substrathalters sind, und daß der Substrathalter in zwei Koordinatenrichtungen parallel zur Fläche der Blendenöffnung bewegt wird. Bevorzugte Ausführungsformen des Verfahrens nach Anspruch 1 sind in den Ansprüchen 2 bis 12 beansprucht.

Da auch die filmbildenden Gaskomponenten vor der Blendenöffnung eingeleitet werden, ist der die Blendenöffnung verlassende Gasstrom homogen durchmischt. Dann werden die Ausgangsmaterialien vollständig ausgenutzt. Die entstehenden Beschichtungsfilme haben im gesamten Flächenbereich des von der Blendenöffnung ausgehenden Strömungskegels eine homogen gleichmäßige Struktur. Für die Homogenität des Schichtaufbaus ist eine einzige Blendenöffnung vorteilhaft, da im Falle von mehreren Blendenöffnungen praktisch nicht erreichbar ist, daß die aus diesen austretenden Gasströme die gleiche Zusammensetzung haben. Um eine Abscheidung von Anteilen der Prozeßgase an anderen Oberfläche als der Substratoberfläche zu vermeiden, ist eine Blende mit einer Wandungsdicke von höchstens 1 mm vorgesehen. Insbesondere wäre auch die Gaszusammensetzung über die Fläche einer länglichen Blendenöffnung ungleichmäßig. Deshalb ist es vorteilhaft, wenn die lichten Weiten der Blendenöffnung in allen Richtungen nur wenig voneinander abweichen. Besonders geeignet sind quadratische und vorzugsweise kreisförmige Blendenöffnungen.

In einem relativ zu den Abmessungen des Substrathalters und damit der gesamten Beschichtungsfläche kleinen Strömungskegel ist über dessen wirksame Fläche eine optimale Homogenität der Gaszusammensetzung, des Anregungszustandes und der Strömungsgeschwindigkeiten erreichbar. Dennoch sind auch großflächige Substrate bzw. eine Vielzahl von auf dem Substrathalter angeordneten kleinflächigen Substraten uniform und homogen zu beschichten, weil der Substrathalter in zwei Koordinatenrichtungen gegenüber der Blendenöffnung bewegt wird.

Die angeregten Ausgangsstoffe werden vorzugsweise durch die Öffnung einer in die Trennwand eingesetzten, auswechselbaren Blende in den Beschichtungsbereich geleitet.

Die Anregung der Ausgangsstoffe findet vorzugsweise mittels Mikrowellen in einem Niederdruckplasma statt. Die Anregung der Ausgangsstoffe kann aber auch mittels anderer Energiequellen erfolgen, z.B. Laser, Glimmentladung oder Lichtbogen.

Das Plasma brennt vorzugsweise unmittelbar über der Blendenöffnung im Anregungsbereich.

Die Relativbewegung besteht vorzugsweise aus einer Kombination einer Rotations- und einer Translationsbewegung.

Vorzugsweise werden mehrere Anregungs- und Gaszufuhreinheiten zur Abscheidung verschiedener Materialien gleichzeitig an mehreren Positionen einer mit Vakuum beaufschlagten Substratkammer angeschlossen.

Dabei ist es zweckmäßig, daß das Substrat der Reihe nach an verschiedenen Positionen vorbeigeführt wird und durch eine Beschichtung mit verschiedenen Materialien eine Schichtfolge, beispielsweise ein Interferenzfilter aufgebaut wird.

Eine mögliche Ausführungsform sieht vor, die Anregungs- und Gaszufuhreinheiten auf einem Kreis anzuordnen und in der Substratkammer mehrere Substrathalter auf einer Art Karussell anzuordnen, so daß mehrere Substrate im Takt an den Beschichtungspositionen vorbeigeführt und gleichzeitig beschichtet werden.

Vorzugsweise wird beim erfindungsgemäßen Verfahren eine Substratkammer verwendet, die einen Einschleuse- und Entnahmemechanismus für Substrate besitzt und so einen kontinuierlichen Betrieb ermöglicht.

Eine homogene Keimbildung in der Gasphase wird vorzugsweise dadurch vermieden, daß das Plasma bis auf die Blendenöffnung vollständig durch Kontakt mit Festkörperoberflächen eingegrenzt wird.

Bei einer anderen Ausführungsform des erfindungsgemäßen Verfahrens wird durch Schaffung eines Anteils von freiem, nicht an eine Festkörperoberfläche grenzendem Plasmabereich eine homogene Keimbildung ermöglicht, und die entstehenden Partikel werden in eine Matrix aus kompaktem Schichtmaterial eingelagert.

Bei noch einer anderen Ausführungsform des erfindungsgemäßen Verfahrens werden einzulagernde Partikel mit dem Strom der Reaktionsgase über die Düse zugegeben und in eine aufwachsende Schicht eingebaut.

Vorteile und Unterschiede des erfindungsgemäßen Verfahrens gegenüber dem bekannten Verfahren:
(1) Anregungs- und Reaktionszone sind durch die Blende vom Abscheide- und Substratraum getrennt.
(2) Die Gasführung ist eindeutig definiert.
(3) Ein Blendenwechsel ist leicht möglich.
(4) Es können sowohl kompakte als auch poröse und partikeldurchsetzte Schichten hergestellt werden.

Diese und andere (im einzelnen angegebene) Gesichtspunkte der Erfindung werden in den nachfolgenden Ausgestaltungen der Erfindung offenbart und erläutert.

Ausführungsbeispiele der Erfindung sind in einer Zeichnung dargestellt und werden im folgenden näher beschrieben.

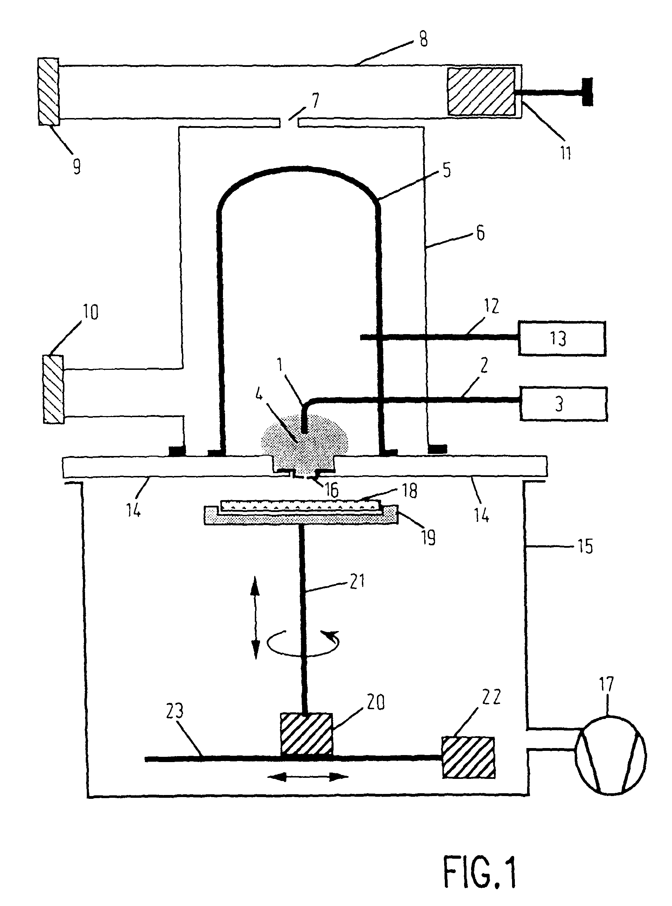

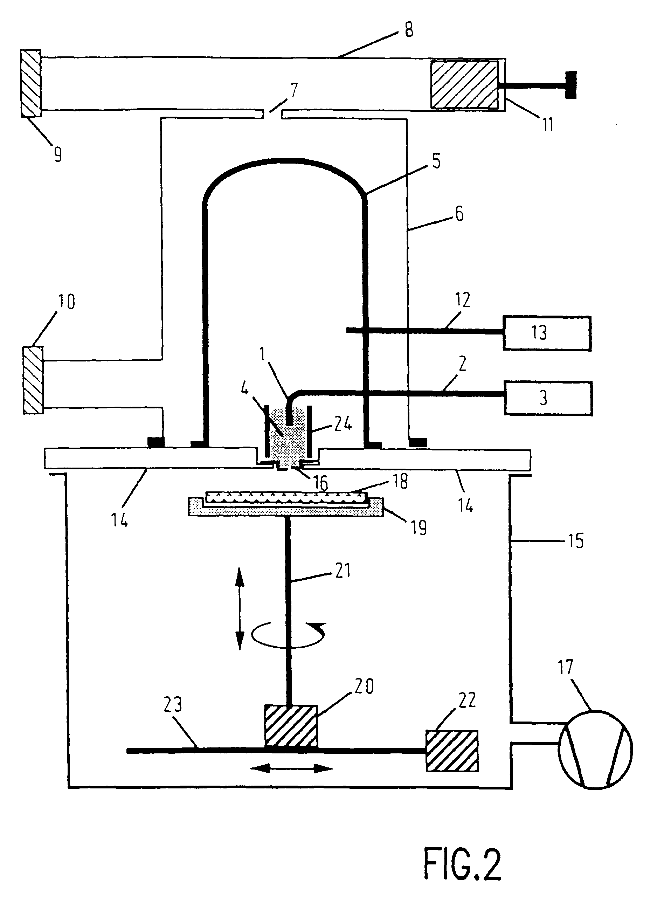

In der Zeichnung zeigen
- Fig. 1 und 2: je eine Vorrichtung zur Durchführung eines Beschichtungsverfahrens schematisch in Seitenansicht.

In Fig. 1 und 2 ist eine Düse 1 über eine Rohrleitung 2 mit einer üblichen Gasversorgung 3 für Reaktions- und Trägergase verbunden. Die Gase werden über die Düse 1 in einen Anregungsbereich 4, z.B. ein Plasma in einer Reaktionskammer 5, geführt. Die Reaktionskammer befindet sich in einem Mikrowellenapplikator 6, der über eine Koppelstelle 7 mit einem Mikrowellenhohlleiter 8 zur Energiezuführung verbunden ist. Stutzen 9 und 10 dienen zum Anschluß von Mikrowellengeneratoren oder von Abstimmelementen. Ein Abstimmelement 11 ist als Kurzschlußschieber angedeutet. Über eine Rohrleitung 12 kann ein weiteres Gas oder Gasgemisch aus einer üblichen Gasversorgung 13, die eine Einheit mit der Gasversorgung 3 bilden oder getrennt aufgebaut sein kann, außerhalb des Anregungsbereichs 4 der Reaktionskammer 5 zugeführt werden. Eine Trennwand 14 trennt die Reaktionskammer 5 von einer Substratkammer 15. Eine Blendenöffnung in einer Blende 16 stellt die Verbindung beider Kammern 5 und 15 her. In der gesamten Anordnung kann mittels einer an der Substratkammer 15 angeschlossenen Pumpe 17 ein Unterdruck erzeugt und aufrechterhalten werden. In der Substratkammer 15 befindet sich ein Substrat 18 auf einem Substrathalter 19. Dieser Substrathalter ist mit einem Bewegungsmechanismus 20 bis 23 verbunden. Ein Motor 20 ermöglicht über eine Achse 21 die Drehung des Substrats. Die Achse 21 ist längenvariabel und erlaubt eine vertikale Positionierung des Substrats. Die Baugruppe aus Substrathalter 19 mit Substrat 18 sowie Motor 20 und Achse 21 ist auf einer durch einen Motor 22 angetriebenen Verschiebeeinheit 23 montiert und kann so horizontal verfahren werden. In Fig. 2 ist zusätzlich ein Quarzrohr 24 dargestellt, dessen Funktion später erläutert wird.

Die beim erfindungsgemäßen Verfahren zu beschichtende Oberfläche des Substrats ist im einfachsten Fall planar, sie kann aber auch in später näher erklärter Form gekrümmt sein. Die herzustellende Beschichtung ist im einfachsten Fall über die Substratoberfläche homogen mit konstanter Dicke. Es können aber auch Schichtdickenprofile erzeugt werden. Die erreichbaren Profile sind abhängig von der Substratform. Bei planaren Substraten beispielsweise sind Profile der allgemeinen Form d = f(r) erzeugbar, wobei d die Schichtdicke und f(r) eine Funktion des Abstandes r von einem Mittelpunkt ist. Des weiteren ist eine Strukturierung der Beschichtung in Wachstumsrichtung möglich, z.B. durch Dotierungsprofile oder eine Schichtenfolge verschiedener Materialien.

Neben der definierten Einstellung des Schichtdickenprofils ist ein weiterer Vorteil des erfindungsgemäßen Verfahrens die Möglichkeit, sowohl kompakte amorphe bzw. (poly)kristalline Schichten als auch Schichten mit einem vorgebbaren Gehalt an Partikeln in einer kompakten Matrix herzustellen. Das Material der eingelagerten Partikel kann gleich dem oder verschieden von dem Material der Matrix sein. Solche Einlagerungen können dienen zur Änderung oder Erzeugung bestimmter physikalischer Eigenschaften wie elektrische Leitfähigkeit, mechanische Festigkeit, optische Absorption oder Lichtstreuung, die im homogenen Material ohne eingelagerte Partikel in der Form oder Ausprägung nicht vorhanden sind.

Jedes Beschichtungsverfahren ergibt durch den Beschichtungsvorgang eine Rückwirkung bzw. Belastung des Substrats, z.B. hohe thermische Belastung, Laserbestrahlung, Beschuß mit energiereichen Elektronen, Ionen oder Neutralteilchen oder auch Einwirkung von UV-Quanten aus einem brennenden Plasma. Diese Belastungen können im Einzelfall wünschenswerte, aber auch schädigende Auswirkungen auf das Substrat haben. Das erfindungsgemäße Verfahren besitzt den weiteren Vorzug, daß bei ihm die energetische Kopplung zwischen Anregung und Temperaturbelastung des Substrats in weiten Grenzen durch zusätzliche Heizung oder die Aufenthaltszeit unter der Blendenöffnung definiert variiert werden kann.

Das bisher vor allem zur Herstellung von Glasfasern für die optische Nachrichtentechnik angewendete Verfahren der plasmaaktivierten chemischen Gasphasenabscheidung (PCVD) ist zur Herstellung obengenannter dielektrischer optischer Schichten besonders geeignet. Es zeichnet sich aus durch die Möglichkeit, Mehrkomponentensysteme mit sehr guter Reproduzierbarkeit bei hoher Wachstumsrate und geringer Substrattemperatur auf unterschiedlichen Substraten abzuscheiden. Ein wesentliches Problem für die Übertragung dieses Verfahrens auf andere Anwendungen neben der Faserherstellung ist die Beschränkung in der Substratgeometrie. Dieses Problem wird durch die Erfindung überwunden.

Der Grundgedanke der Erfindung ist die Erzeugung eines im Vergleich zu den Substratabmessungen eng begrenzten Beschichtungsbereichs, der dann über die Substratoberfläche derart verlagert und verfahren wird, daß eine Beschichtung des gesamten Substrats mit dem gewünschten Schichtprofil entsteht. Die Schichterstellung kann bei dem erfindungsgemäßen Verfahren grob in vier Schritte unterteilt werden:
1 Bereitstellung und Zuführung der Ausgangsstoffe
2 Anregung der reaktionsfähigen Komponenten der Ausgangsstoffe
3 Erzeugung des engen Beschichtungsbereichs
4 Aufwachsen der Schicht auf dem Substrat

Zu 1: Die Ausgangsstoffe werden in bekannter Weise mittels einer konventionellen Gasversorgung dosiert und einem Anregungsbereich zugeführt.
Zu 2: In diesem Anregungsbereich werden die gasförmigen Ausgangsstoffe z.B. durch ein Mikrowellen-Niederdruckplasma angeregt.
Zu 3: Dieses so angeregte Gas wird durch eine Öffnung in einer Trennwand zwischen einer den Anregungsbereich enthaltenden Reaktionskammer und einer den Beschichtungsbereich enthaltenden Substratkammer vom Anregungsbereich in den Beschichtungsbereich geleitet. Die Öffnung in der Trennwand wird nachfolgend kurz "Blendenöffnung" genannt. Entsprechend dem Druckgefälle zwischen Gasversorgungsausgang und Pumpeneingang und dem Fließwiderstand der verschiedenen Komponenten bildet sich zwischen den beiden Bereichen je nach Gesamtgasfluß ein Druckunterschied aus. Dieser führt zu einem, entsprechend der Größe der Blendenöffnung, in seinem Querschnitt begrenzten Gasstrom durch die Blendenöffnung in Richtung Substrat.
Zu 4: Auf der Substratoberfläche werden die kondensierbaren Anteile des Gasstromes abgeschieden.

Im folgenden wird das Beispiel eines planaren Substrats gewählt. Bei einem ruhenden Substrat bewirkt der Gasstrom eine rotationssymmetrische Beschichtung, wobei der Mittelpunkt unter der Blendenöffnung liegt. Form und Breite des Schichtprofils sind abhängig vom Durchmesser der Blendenöffnung, dem Abstand zwischen Blendenöffnung und Substrat sowie dem gewählten Gesamtgasfluß.

Dieses enge Beschichtungsprofil wird nun über den gesamten zu beschichtenden Bereich hinwegbewegt. Im Prinzip ist jede geeignete Relativbewegung von Blendenöffnung und Substrat möglich. Als besonders günstig erscheint die Kombination aus einer Drehung des Substrats um seinen Mittelpunkt und einer Translation des Substrats an der Blendenöffnung vorbei.

Dabei haben die beiden Bewegungen so zu erfolgen, daß die Bewegung des Mittelpunktes der Drehung auf einer Geraden (oder einem Kreisbogen mit großem Krümmungsradius) erfolgt, die direkt oder in nur geringem Abstand an der Blendenöffnung vorbeiführt. Mit anderen Worten, das Beschichtungsprofil muß mindestens mit seinem Ausläufer über den Drehpunkt geführt werden.

Die genannten Bewegungen führen wie folgt zu der gewünschten Beschichtung der gesamten Fläche: Bei einer Drehung des Substrats ohne Translation ergibt sich auf der Oberfläche eine kreisförmige Beschichtungsspur, wenn Drehpunkt und Blendenmittelpunkt nicht auf einer gemeinsamen Achse liegen, wobei die Schichtdickenverteilung über dem Umfang gleichmäßig ist. Bei gleichzeitiger Rotation und Translation ergibt sich eine spiralförmige Beschichtung. Eine Bewegung des Substrats vom Rand zum Drehpunkt hin an der Blendenöffnung vorbei ergibt dabei eine enger werdende Spirale, eine Verschiebung vom Drehpunkt zum Rand hin entsprechend eine sich erweiternde Spirale. Die Steigung der Spirale hängt ab vom Verhältnis der Winkel- zur Vorschubgeschwindigkeit. Bei gegebenem statischem Beschichtungsprofil kann durch geeignete Wahl der beiden Geschwindigkeiten für jeden Punkt der Translation der gewünschte Schichtdickenverlauf auf dem Substrat erreicht werden. Für die gleichmäßige Beschichtung eines ebenen Substrats muß der Vorschub zur Mitte hin schneller erfolgen als bei der Beschichtung der Randbereiche.

Bei hoher Drehzahl verglichen mit den Vorschubgeschwindigkeiten (d.h. viele Beschichtungsumläufe an der Stelle r) entstehen Beschichtungen, deren Dicke vom Drehwinkel nahezu unabhängig ist. Durch Änderung der Schichtdicke im Verlaufe der Translation etwa durch Änderung von Geschwindigkeit oder Gesamtfluß, ergeben sich also Profile, die nur vom Abstand r der Blendenöffnung zum Drehpunkt abhängen (d = f(r), wie oben erwähnt).

Dabei kann der Drehpunkt durch entsprechende Halterung des Substrats auf dem Drehteller auch asymmetrisch auf dem Substrat oder sogar ganz außerhalb des Substrats liegen, wenn z.B. mehrere kleine Substrate gleichzeitig auf einem Substrathalter beschichtet werden.

Durch die Kombination von Dreh- und Linearbewegung kann z.B. der zylinderförmige Kolben einer linearen Halogenglühlampe außenbeschichtet werden. Dazu wird der Lampenkolben durch eine Halterung mit seiner Achse parallel zur Ebene der Blendenöffnung ausgerichtet, so daß diese Achse unter der Blendenöffnung entlangführt. Durch Drehung der Lampe um die Kolbenachse wird eine über den Umfang gleichmäßige Beschichtung erreicht. Durch Vorfahren des Kolbens entlang seiner Achse wird der gesamte Kolben an der Blendenöffnung vorbeigeführt und beschichtet. Hierbei kann man durch Veränderung der Vorschubgeschwindigkeit oder des Gasflusses sehr einfach Dickenprofile entlang der Kolbenachse erzeugen, um z.B. bei Interferenzfiltern Winkeleffekte auszunutzen.

Durch die beiden angeführten Beispiele wird deutlich, daß dieses Verfahren die Möglichkeit eröffnet, eine Vielzahl von Substratformen in definierter Weise zu beschichten. Es muß dabei nur gewährleistet sein, daß die Form des Substrats ein gleichmäßiges Vorbeiführen der gesamten zu beschichtenden Oberfläche an der Blendenöffnung nicht verhindert. Innenräume und scharfe Kanten sind Beispiele für solche Behinderungen.

Es folgen einige Anmerkungen zu einzelnen Komponenten und Prozeßschritten.

Gaszuführung: Zur optimalen Anregung und Ausbeute der gasförmigen Ausgangsstoffe kann es vorteilhaft sein, die Gase mittels einer Düse gleich in die Nähe der Blendenöffnung zu führen. In diesem Fall kann eine getrennte Zuführung von Gasen zum Zünden des Plasmas oder zum Spülen nötig sein. Ein Pumpen an der Reaktionskammer sowie eine Zufuhr von Spül- und Füllgasen in die Substratkammer ist ebenfalls möglich.

Anregung des Gases: Um eine möglichst hohe Konzentration an angeregten Spezies zum Substrat zu bringen, ist es zweckmäßig, daß das Plasma ohne Zwischenraum über der Blendenöffnung brennt. Dies hat den weiteren Vorteil, daß alles Gas, das den Beschichtungsbereich erreicht, durch das Plasma gegangen sein muß, und so ein hoher Anregungswirkungsgrad erreicht wird. Auch ist zu beachten, daß eine nahezu vollständige Zerlegung der Ausgangsstoffe den Einsatz toxischer Ausgangsstoffe wesentlich unproblematischer gestalten kann, wenn zwar der Ausgangsstoff, nicht aber die entstehenden Endprodukte gefährlich sind. Zur Lokalisierung des Plasmas über der Blendenöffnung in der skizzierten Mikrowellen-Hohlleiteranordnung hat es sich in manchen Fällen als zweckmäßig erwiesen, eine Elektrode in geringer Höhe (etwa 5 bis 15 mm) über der Blendenöffnung anzubringen. Diese Elektrode ist als Rohr ausgebildet und wird zur Zuführung der Gase benutzt.

Gasdurchtrittsblende: Um möglichst wenig Wechselwirkung der angeregten Gase mit dem Blendenmaterial zu haben, sollte die Blende im Bereich der Öffnung möglichst dünn sein, z.B. höchstens etwa 1 mm Dicke. Dabei kann der Rand noch als eine Art Schneide ausgeführt werden, um den Kontakt weiter zu reduzieren. Die Blende ist so ausgeführt, daß sie als Einheit leicht aus der Trennwand herausgenommen und ersetzt werden kann. Der Durchmesser der Blendenöffnung liegt je nach gefordertem Beschichtungsprofil im Bereich 1 bis 10 mm.

Trennwand: enthält gegebenenfalls eine Kühlung zur Abfuhr der eingebrachten Mikrowellenleistung. Substrathalterung: Die genaue Ausführung richtet sich nach Form und Größe des jeweiligen Substrats. Für eine runde Glasplatte ist der Halter ein Drehteller mit Kragen zur seitlichen Festlegung des Substrats. Zur Einstellung einer Grundtemperatur für die Beschichtung des Substrats ist eine Heizeinrichtung vorgesehen. Diese kann als Widerstandsheizung in den Halter integriert sein oder von ihm getrennt als Strahlungsheizung.

Verschluß: Zur Einstellung konstanter Verhältnisse zu Beginn des Prozesses ist gegebenenfalls ein Verschluß vorgesehen, der zwischen Blendenöffnung und Substrat angeordnet werden kann und das Substrat anfänglich vor Beschichtung schützt.

Bewegungsmechanismus: Der Bewegungsmechanismus ermöglicht eine Dreh- und zwei Linearbewegungen. Die vertikale Verschiebung dient zur Einstellung eines Abstandes Blende-Substrat im Bereich 1 bis 20 mm. Horizontal- und Drehbewegung sorgen für den Aufbau des Beschichtungsprofils. Dabei ist der Bereich der Horizontalbewegung mindestens so groß, daß sie größer ist als die größte Ausdehnung der zu beschichtenden Fläche. Das Verhältnis von minimaler zu maximaler Vorschub- bzw. Drehgeschwindigkeit ist möglichst groß, etwa 1:1000.

Zur Herstellung großer Stückzahlen von Schichtstrukturen, z.B. Interferenzfilter für Frontplatten von Bildröhren (etwa 20 Schichten SiO₂/TiO₂), ist folgende Anordnung zweckmäßig: Eine große evakuierbare Substratkammer enthält Substrathalter und Bewegungsmechanismen für eine größere Anzahl von Substraten auf einem Karussell. Der Deckel der Reaktionskammer enthält an entsprechenden Positionen mehrere Plasmaanregungseinheiten, die jeweils zur Beschichtung von SiO₂ oder TiO₂ dienen. Die Einheiten für beide Materialien sind abwechselnd angeordnet. Die Substrathalter werden im Takt jeweils eine Position weiter gerückt, so daß das Schichtpaket schrittweise aufbaut und nach einer entsprechenden Zahl von Schritten, die einen oder mehrerer Umläufe benötigen können, fertig ist. Je ein Schleusenmechanismus zur Zugabe und Entnahme der Substrate am Anfang und Ende des Prozesses erlauben einen kontinuierlichen Betrieb mit hohem Durchsatz.

Das erfindungsgemäße Verfahren mit einer Trennung von Anregung der Reaktionsstoffe und Abscheidung auf dem Substrat in zwei räumlich getrennte Bereiche, mit einem Durchgang mittels einer Blendenöffnung geringen Querschnitts, verhindert weitgehend eine Einwirkung von Partikeln oder Strahlung aus dem Anregungsbereich, hier z.B. des Plasmas, auf das Substrat. Des weiteren kann die Stärke der verbleibenden Einwirkung durch Regulierung der Verweildauer eines Flächenelementes des Substrats unter der Blendenöffnung eingestellt werden. Diese Verweildauer wird z.B. durch die Rotationsgeschwindigkeit des Substrats bestimmt.

Ähnlich wie beim PCVD-Prozeß zur Herstellung von Lichtleitfasern sollte man erwarten, daß ein in eine Plasma- bzw. Reaktionszone eingeleitetes Gasgemisch vollständig zerlegt wird und über konvektive und diffusive Transportprozesse atomar oder molekular bis zu den Wandungen gelangt und dort in Form kompakter Schichten kondensiert. In der Anordnung nach Fig. 1 sollte man also eine erwünschte Abscheidung auf dem Substrat 18, aber auch eine unerwünschte Teilkondensation auf der Oberseite der Trennwand sowie der Ober- und Unterseite der Blende erwarten. Im Falle eines transparenten Materials also eine klare Schicht. Tatsächlich zeigen die Experimente jedoch trübe Schichten.

Gründe für dieses Verhalten liefert eine Betrachtung des erfindungsgemäßen Verfahrens in seiner Ausführung gemäß Fig. 1. Die Reaktionsgase werden über die Düse 1 in den Anregungsbereich 4, hier ein Plasma in der Reaktionskammer 5, geführt und dort angeregt. Die zugeführte Gasmenge muß die Reaktionskammer 5 letztlich durch die Blendenöffnung in der Blende 16 wieder verlassen, bis auf den Teil, der an einer der Kammerwände niedergeschlagen wird. Bei diesem Durchgang durch die Reaktionskammer wird sich ein mehr oder weniger ausgedehntes Flußfeld zwischen Düse und Blendenöffnung ausbilden, und die Gase haben eine gewisse Aufenthaltsdauer in der Reaktionskammer. Ein Anteil der angeregten Gase wird entweder entlang der Flußlinien oder mittels Diffusion an den freien nicht durch Oberflächen abgedeckten Rand des Plasmas gelangen. In diesem Randbereich und außerhalb davon fällt aber die Leistungsdichte im Plasma unter einen kritischen Wert, und durch homogene Keimbildung in der Gasphase entstehen Partikel des Schichtmaterials. Ein Teil dieser Partikel wird durch Rückdiffusion oder den Gasfluß wieder in das Plasma gelangen. Die beim PCVD-Prozeß auftretenden Leistungsdichten reichen jedoch nicht aus, um einmal bestehende Partikel wieder vollständig aufzulösen. Es ist vielmehr auch möglich, daß die Partikel selbst als Substrat dienen und ein Weiterwachsen dieser Partikel auftritt. Die Partikel können daher mit dem Gasstrom durch das Plasma hindurch zur Blendenöffnung und zum Substrat gelangen. Dort werden sie in die entstehende Schicht eingebaut, die durch den Anteil der Ausgangsstoffe, die das Plasma nicht verlassen haben, gebildet wird.

Überraschenderweise kann dieser unerwünschte Effekt der Partikeleinlagerung und Schichttrübung jedoch gänzlich vermieden werden, wenn statt der Anordnung nach Fig. 1 eine Anordnung wie in Fig. 2 skizziert eingesetzt wird. In der Anordnung nach Fig. 2 wird die Entstehung von Partikeln vermieden, indem auf der Trennwand 14 ein Stück Quarz- oder Glasrohr 24 konzentrisch um die Blendenöffnung angeordnet wird. Die Höhe dieses Rohres ist so gewählt, daß die Spitze der Düse einige mm in das Rohr hineinreicht. Bei richtiger Abstimmung brennt das Plasma zwischen Düse und Trennwand im Inneren dieses Glasrohres. Dabei füllt das Plasma den gesamten Rohrquerschnitt aus. Die Folge ist, daß die Partikel, die ohne Glasrohr an den Plasmarand gelangt wären und zur Partikelerzeugung beigetragen hätten, nun auf die Innenwand des Rohres treffen und dort in einer kompakten Schicht festgehalten werden, ähnlich der normalen PCVD in einem Rohrreaktor. Durch die Blendenöffnung und zum Substrat gelangen nur Partikel, die nach der Anregung das Plasma nicht verlassen haben, so daß keine Keimbildung stattfindet und die gebildete Schicht ohne Partikeleinschluß bleibt.

### Ausführungsbeispiel 1:

In folgenden wird die Herstellung eines einfachen SiO₂/TiO₂-Interferenzfilters beschrieben. Als Substrat 18 wird eine Quarzglasplatte (Fig. 2) von 5 cm Durchmesser in den Substrathalter 19 eingelegt und auf 320°C erwärmt. Das Substrat wird mit einer Geschwindigkeit von 30 U/min um seinen Mittelpunkt gedreht und mit einer Hublänge von 6 cm vollständig an der Blendenöffnung der Blende 16 vorbeigeführt. Die Translation durchläuft in Abhängigkeit von der Position ein Zeitprogramm mit einer minimalen Vorschubgeschwindigkeit von 0,2 mm/sec.

Zur Schichtherstellung werden zwei Gasgemische verwendet, SiCl₄/O₂/Ar mit einem Gesamtfluß von 18 sccm zur SiO₂-Bildung und TiCl₄/O₂/Ar mit einem Gesamtfluß von 25 sccm zur TiO₂-Bildung. Beide Gemische können abwechselnd in die Reaktionskammer 5 eingeleitet werden. Die Gase werden durch die Düse 1 in das Quarzrohr 24 von 12 mm Innendurchmesser und 25 mm Länge in der Reaktionskammer 5 eingelassen. In dem Quarzrohr werden die Gase im Anregungsbereich 4 mittels eines Niederdruckplasmas angeregt (300 W Mikrowellenausgangsleistung eines Magnetrons) und durch die Blende 16 mit einer Blendenöffnung von 3 mm Durchmesser in einen Beschichtungsbereich, hier die Substratkammer 15, auf das 6 mm entfernte Substrat 18 geleitet. Der Druck in der Substratkammer beträgt 0,9 hPa.

Gasfluß und Vorschubgeschwindigkeit sind so ausgelegt, daß die nötigen Schichtdicken von 190 nm pro SiO₂-Schicht in einem Hub und von 118 nm pro TiO₂-Schicht in drei Hüben erreicht wird. Das nach Aufbringung von vier Doppelschichten erzeugte Filter ist über der Substratfläche homogen mit einer Welligkeit unter 2%.

Die Beseitigung der Maßnahmen zur Unterdrückung der Keimbildung führt zu einer völlig neuen Variante der Materialherstellung, nämlich der uniformen Herstellung von Schichten mit eingelagerten amorphen bzw. kristallinen Partikeln. Derartige Materialien sind aus dem Bereich der Keramik und Glas/Keramik bekannt, wobei allerdings die Herstellungsprozesse Hochtemperaturschritte enthalten, in denen Entmischungen und Festkörperausscheidungen stattfinden.

Das erfindungsgemäße Verfahren sieht die simultane Abscheidung von Partikeln in einer kompakten Matrix vor, wobei die Partikel aus dem gleichen Material wie die Matrix oder aber aus einem anderen Material bestehen können. Beispiele für mögliche Anwendungsbereiche sind Blendschutz-, Antistatik- oder Nullextensions-Schichten.

Die Beobachtung, daß Partikel in den hier benutzten Plasmen nicht vollständig aufgelöst werden, kann genutzt werden zur Einlagerung von Partikeln aus einem anderen Material als dem Schichtmaterial, z.B. Metallpartikel eingebracht in eine dielektrische Schicht. Dazu werden die einzulagernden Partikel, die vorher z.B. durch Laserverdampfen eines aus dem Partikelmaterial bestehenden Festkörpers erzeugt wurden, mit dem Gasstrom der Reaktions- und Zündgase für die dielektrische Schicht über die Düse durch das Plasma und die Blendenöffnung zum Substrat transportiert. Dort werden sie in die aufwachsende Schicht eingebaut.

### Ausführungsbeispiel 2:

Es wird die Herstellung einer SiO₂-Schicht mit eingelagerten SiO₂-Partikeln beschrieben. Eine Quarzglasplatte (Fig. 1) von 5 cm Durchmesser wird als Substrat 18 in den Substrathalter 19 eingelegt und auf 320°C erwärmt. Wie im vorhergehenden Ausführungsbeispiel wird das Substrat mit einer Geschwindigkeit von 30 U/min um seinen Mittelpunkt gedreht und mit einer Hublänge von 6 cm mehrfach vollständig an der Blendenöffnung vorbeigeführt. Dabei durchläuft die Translation in Abhängigkeit vom Ort ein Geschwindigkeitsprogramm.

Zur Schichtherstellung wird ein Gasgemisch SiCl₄/O₂/Ar mit einem Gesamtfluß von 28 sccm verwandt. Die Gase werden durch die Düse 1 in die Reaktionskammer 5 eingelassen und mittels eines Niederdruckplasmas im Anregungsbereich 4 angeregt (960 W Mikrowellenausgangsleistung eines Magnetrons). Durch die Blende 16 mit einer Öffnung von 3 mm Durchmesser werden die Gase in die Substratkammer 15 auf das 6 mm entfernte Substrat 18 geleitet. Der Druck in der Substratkammer beträgt 0,8 hPa. Die nach etwa 10 min Beschichtungszeit aufgebrachte Schicht zeigt eine über die Substratfläche gleichmäßige, deutlich sichtbare weißliche Eintrübung.

## Patentansprüche

1. CVD-Verfahren zur Beschichtung großflächiger Substrate, wobei eine Anregung von Ausgangsstoffen und die Beschichtung mindestens eines auf einem Substrathalter angeordneten Substrats in durch eine Trennwand getrennten Bereichen stattfindet, die angeregten Ausgangsstoffe durch eine Öffnung in der Trennwand vom Anregungsbereich in den Beschichtungsbereich geleitet werden und der Substrathalter relativ zu der Öffnung bewegt wird,
dadurch gekennzeichnet,
daß sämtliche Prozeßgase in den Anregungsbereich geführt werden, daß die angeregten Prozeßgase danach durch eine einzige Öffnung einer zugeordneten Blende in den Beschichtungsbereich geführt werden, daß die Wandungsdicke der Blende höchstens 1 mm beträgt, daß die lichten Weiten wesentlich kleiner als die Abmessungen des Substrathalters sind, und daß der Substrathalter in zwei Koordinatenrichtungen parallel zur Fläche der Blendenöffnung bewegt wird.

2. Verfahren nach Anspruch 1,
dadurch gekennzeichnet, daß die angeregten Ausgangsstoffe durch die Öffnung einer in die Trennwand eingesetzten, auswechselbaren Blende in den Beschichtungsbereich geleitet werden.

3. Verfahren nach Anspruch 1 oder 2,
dadurch gekennzeichnet, daß die Anregung der Ausgangsstoffe mittels Mikrowellen in einem Niederdruckplasma stattfindet.

4. Verfahren nach Anspruch 3,
dadurch gekennzeichnet, daß das Plasma unmittelbar über der Blendenöffnung im Anregungsbereich brennt.

5. Verfahren nach einem der Ansprüche 1 bis 4,
dadurch gekennzeichnet, daß die Relativbewegung aus einer Kombination einer Rotations- und einer Translationsbewegung besteht.

6. Verfahren nach Anspruch 1,
dadurch gekennzeichnet, daß mehrere Anregungs- und Gaszufuhreinheiten zur Abscheidung verschiedener Materialien gleichzeitig an mehreren Positionen einer mit Vakuum beaufschlagten Substratkammer angeschlossen werden.

7. Verfahren nach Anspruch 6,
dadurch gekennzeichnet, daß das Substrat der Reihe nach an verschiedenen Positionen vorbeigeführt wird und durch eine Beschichtung mit verschiedenen Materialien eine Schichtfolge aufgebaut wird.

8. Verfahren nach Anspruch 6 oder 7,
dadurch gekennzeichnet, daß die Anregungs- und Gaszufuhreinheiten auf einem Kreis angeordnet werden und in der Substratkammer mehrere Substrathalter auf einer Art Karussell angeordnet werden, und daß mehrere Substrate im Takt an den Beschichtungspositionen vorbeigeführt und gleichzeitig beschichtet werden.

9. Verfahren nach einem der Ansprüche 6 bis 8,
dadurch gekennzeichnet, daß eine Substratkammer verwendet wird, die einen Einschleuse- und Entnahmemechanismus für Substrate besitzt.

10. Verfahren nach einem der Ansprüche 1 bis 9,
dadurch gekennzeichnet, daß das Plasma bis auf die Blendenöffnung vollständig durch Kontakt mit Festkörperoberflächen eingegrenzt wird.

11. Verfahren nach einem der Ansprüche 1 bis 9,
dadurch gekennzeichnet, daß durch Schaffung eines Anteils von freier, nicht an eine Festkörperoberfläche grenzenden Plasmabereiches homogene Keimbildung ermöglicht wird, und die entstehenden Partikel in eine Matrix aus kompaktem Schichtmaterial eingelagert werden.

12. Verfahren nach einem der Ansprüche 1 bis 11,
dadurch gekennzeichnet, daß einzulagernde Partikel mit dem Strom der Reaktionsgase über die Düse zugegeben und in eine aufwachsende Schicht eingebaut werden.

## Claims

1. A CVD process for coating extensive substrates, in which starting materials are excited and at least a substrate arranged on a substrate holder is coated in areas which are separated by a partition, said excited starting materials being fed from the excitation region to the coating region through an aperture in said partition, and the substrate holder being moved relative to said aperture, characterized in that all process gases are introduced into the excitation region, whereafter the excited process gases are passed through a single aperture of a diaphragm into the coating region, in that the wall thickness of the diaphragm is maximally 1 mm, the inside diameter is much smaller than the dimensions of the substrate holder, and in that the substrate holder is moved into coordinate directions parallel to the phase of the diaphragm aperture.

2. A method as claimed in Claim 1, characterized in that the excited starting substances are passed through the aperture of an exchangeable diaphragm placed in the partition, into the coating region.

3. A method as claimed in Claim 1 or 2, characterized in that the starting substances are excited by means of microwaves in a low-pressure plasma.

4. A method as claimed in Claim 3, characterized in that the plasma burns right above the diaphragm aperture in the excitation range.

5. A method as claimed in any one of Claims 1 to 4, characterized in that the relative movement consists of a combination of a rotary and a translatory movement.

6. A method as claimed in Claim 1, characterized in that, to deposit various materials, a plurality of excitation and gas-supply units are simultaneously connected, in various locations, to an evacuated substrate chamber.

7. A method as claimed in Claim 6, characterized in that the substrate is sequentially fed past various positions, and a layer sequence is formed by coating it with various materials.

8. A method as claimed in Claim 6 or 7, characterized in that the excitation and gas-supply units are circularly arranged and a plurality of substrate holders are arranged on a kind of carrocel in the substrate chamber, and in that a plurality of substrates are periodically fed past the coating positions and are simultaneously coated.

9. A method as claimed in any one of Claims 6 to 8, characterized in that a substrate chamber is used which comprises an inward transfer mechanism and a removal mechanism for substrate.

10. A method as claimed in any one of Claims 1 to 9, characterized in that up to the diaphragm aperture the plasma is bounded completely by contact with solid surfaces.

11. A method as claimed in any one of Claims 1 to 9, characterized in that nucleation is made possible by forming a portion of free plasma regions which are not bounded by a solid surface, and the particles thus formed are intercalated in a matrix of compact layer material.

12. A method as claimed in any one of Claims 1 to 11, characterized in that particles to be intercalated are added, via the nozzle, to the flow of reaction gases and are incorporated in a layer which is being grown.

## Revendications

1. Procédé CVD pour le revêtement de substrats étendus, une excitation de substances au départ et le revêtement d'au moins un substrat disposé sur un support de substrat se produisant dans des zones séparées par une cloison de séparation, les substances de départ excitées étant guidées par une ouverture dans la cloison de séparation de la zone d'excitation dans la zone de revêtement et le support de substrat étant déplacé par rapport à l'ouverture,
caractérisé en ce que tous les gaz du processus sont guidés dans la zone d'excitation, en ce que les gaz du processus excités sont ensuite guidés par une seule ouverture d'un filtre affecté dans la zone de revêtement, en ce que l'épaisseur de la cloison du filtre s'élève à 1 mm maximum, en ce que les diamètres intérieurs sont essentiellement inférieurs aux dimensions du support de substrat, et en ce que le support de substrat est déplacé dans deux directions de coordonnées parallèlement à la surface de l'ouverture du filtre.

2. Procédé selon la revendication 1,
caractérisé en ce que les substances de départ excitées sont guidées par l'ouverture d'un filtre remplaçable inséré dans la cloison de séparation dans la zone de revêtement.

3. Procédé selon la revendication 1 ou 2,
caractérisé en ce que l'excitation des substances de départ se produit à l'aide de micro-ondes dans un plasma à basse pression.

4. Procédé selon la revendication 3,
caractérisé en ce que le plasma brûle directement sur l'ouverture du filtre dans la zone d'excitation.

5. Procédé selon l'une des revendications 1 à 4,
caractérisé en ce que le mouvement relatif se compose d'une combinaison d'un mouvement de rotation et d'un mouvement de translation.

6. Procédé selon la revendication 1,
caractérisé en ce que plusieurs unités d'excitation et d'alimentation en gaz sont raccordées simultanément à plusieurs positions d'un compartiment de substrat alimenté en vide en vue du dépôt de différents matériaux.

7. Procédé selon la revendication 6,
caractérisé en ce que le substrat est amené à passer successivement en différentes positions et est composé d'une succession de couches par un revêtement avec différents matériaux.

8. Procédé selon la revendication 6 ou 7,
caractérisé en ce que les unités d'excitation et d'alimentation en gaz sont disposées sur un cercle et plusieurs supports de substrat sont disposés dans le compartiment de substrat à la manière d'un carrousel et que plusieurs substrats sont amenés devant les positions de revêtement en cadence et sont revêtus simultanément.

9. Procédé selon l'une des revendications 6 à 8,
caractérisé en ce qu'un compartiment de substrat est utilisé et possède un mécanisme d'introduction cadencée et de prélèvement pour les substrats.

10. Procédé selon l'une des revendications 1 à 9,
caractérisé en ce que le plasma est totalement confiné par contact avec des surfaces solides jusqu'à l'ouverture du filtre.

11. Procédé selon l'une des revendications 1 à 9,
caractérisé en ce que la formation d'une composante d'une zone de plasma libre qui n'est pas adjacente à une surface solide permet une germination homogène et les particules formées sont incluses dans une matrice en matériau compact de la couche.

12. Procédé selon l'une des revendications 1 à 11,
caractérisé en ce que les particules à inclure sont ajoutées avec le flux des gaz réactifs par l'intermédiaire de la tuyère et sont intégrées dans une couche en cours de formation.
